(19) Europäisches Patentamt

European Patent Office

Office européen des brevets

(11) **EP 3 958 333 B1**

(12) # EUROPEAN PATENT SPECIFICATION

(45) Date of publication and mention
of the grant of the patent:
**29.01.2025 Bulletin 2025/05**

(21) Application number: **20791935.8**

(22) Date of filing: **31.03.2020**

(51) International Patent Classification (IPC):
$H01L\ 33/22^{(2010.01)}$       $H01L\ 33/32^{(2010.01)}$
$H01L\ 21/205^{(2006.01)}$      $H01L\ 29/201^{(2006.01)}$
$H01L\ 29/207^{(2006.01)}$      $H01L\ 33/00^{(2010.01)}$

(52) Cooperative Patent Classification (CPC):
**H01L 21/0262; H01L 21/02458; H01L 21/02502;
H01L 21/0254; H01L 21/02576; H01L 21/02579;
H01L 33/007; H01S 5/34333;** H01L 33/32;
H01S 2301/173; H01S 2304/12

(86) International application number:
**PCT/JP2020/014796**

(87) International publication number:
**WO 2020/213388 (22.10.2020 Gazette 2020/43)**

(54) **COMPOUND SEMICONDUCTOR LAYER LAMINATE AND METHOD FOR FORMING SAME, AND
LIGHT-EMITTING DEVICE**

VERBUNDHALBLEITERSCHICHTLAMINAT UND VERFAHREN ZU DESSEN HERSTELLUNG
SOWIE LICHTEMITTIERENDE VORRICHTUNG

STRATIFIÉ À COUCHE SEMI-CONDUCTRICE COMPOSITE ET SON PROCÉDÉ DE FABRICATION
AINSI QU'UN DISPOSITIF ÉLECTROLUMINESCENT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **19.04.2019   JP 2019079978**

(43) Date of publication of application:
**23.02.2022   Bulletin 2022/08**

(73) Proprietor: **Sony Group Corporation
Tokyo 108-0075 (JP)**

(72) Inventors:
• **TASAI, Kunihiko
Tokyo 108-0075 (JP)**

• **NAKAJIMA, Hiroshi
Tokyo 108-0075 (JP)**
• **KAWANISHI, Hidekazu
Tokyo 108-0075 (JP)**
• **YANASHIMA, Katsunori
Tokyo 108-0075 (JP)**

(74) Representative: **D Young & Co LLP
3 Noble Street
London EC2V 7BQ (GB)**

(56) References cited:
**JP-A- 2003 158 295      JP-A- 2003 158 295
JP-A- 2013 074 278      JP-A- H11 219 909
JP-B2- 3 847 000         US-A1- 2004 262 624**

EP 3 958 333 B1

## Description

Technical Field

The present disclosure relates to a compound semiconductor layer stack, a method of forming the same, and a light-emitting device.

Background Art

Light-emitting devices and electronic devices using a GaN-based compound semiconductor have been actively developed. Examples of the light-emitting device may include a light emitting diode or a semiconductor laser element that emits red light, a light emitting diode or a semiconductor laser element that emits green light, and a light emitting diode or a semiconductor laser element that emits blue light. In addition, examples of the electronic device may include a power semiconductor having functions of a switching element, a power conversion element, and the like, and examples of a display apparatus may include a display apparatus using the light-emitting device. However, a compound semiconductor layer including the GaN-based compound semiconductor has higher density of dislocation (threading dislocation) generated in the compound semiconductor layer and threading in a stacking direction, as compared with a GaAs-based compound semiconductor or a material system of silicon, or the like. When the threading dislocation extends to a functional layer (e.g., an active layer and a light-emitting layer in the light-emitting device,) inside the device, characteristics of the device are deteriorated. Specifically, the threading dislocation causes generation of a leak current in the electronic device. In addition, the threading dislocation not only causes the generation of the leak current, but also becomes a non-emissive coupling center inside the active layer, thus reducing luminous efficiency, in the light-emitting device. Therefore, in a case where a crystal defect (threading dislocation) has high density, it is difficult to obtain a light-emitting device or an electronic device in which properties of the GaN-based compound semiconductor is sufficiently utilized.

For example, Japanese Unexamined Patent Application Publication No. 2007-214380 discloses, as a technique for reducing the threading dislocation density, a technique of growing a GaN-based compound semiconductor layer on a heterogeneous substrate using an insulating layer mask.

Citation List

Patent Literature

PTL 1: Japanese Unexamined Patent Application Publication No. 2007-214380
Document JP 3 847000 B2 discloses as a problem to be solved to provide a method for growing a nitride semiconductor which can be a substrate, with few crystal defects, and to provide a highly reliable nitride semiconductor element. The document discloses a protective film partially formed on a first nitride semiconductor layer grown on a different kind of substrate, and a second nitride semiconductor layer with less crystal defects than the first nitride semiconductor layer grown on the protecting film, in this method for growing a nitride semiconductor. A nitride semiconductor layer, including. In, is formed between the first nitride semiconductor layer and the protecting film so as to be brought into contact with the protecting film, or during the grown of the second nitride semiconductor layer, so that the dislocation of the crystal failure can be stopped. Document US 2004/262624 A1 discloses a GaN substrate comprising a GaN single crystal substrate, an $Al_xGa_{1-x}N$ intermediate layer ($0<x<=1$) epitaxially grown on the substrate, and an GaN epitaxial layer grown on the intermediate layer. The intermediate layer is made of AlGaN and this AlGaN grows over the entire surface of the substrate with contaminants thereon and high dislocation regions therein. Thus, the intermediate layer is normally grown on the substrate, and a growth surface of the intermediate layer can be made flat. Since the growth surface is flat, a growth surface of the GaN epitaxial layer epitaxially grown on the intermediate layer is also flat.
Document JP 2003 158295 A discloses as a problem to be solved: to provide a GaN-based semiconductor, and a method for manufacturing the same, equipped with a structure usable for improvement on the luminescence property of semiconductor light emitting diodes using a GaN-based semiconductor. The document discloses a use of crystal surfaces yet nonplanar in a GaN-based semiconductor film selective growth process for the irregular reflection of light. Non-flat boundaries are formed in between a 1st GaN- based semiconductor and a 2nd GaN-based semiconductor, and in between the 2nd GaN-based semiconductor and a 3rd GaN-based semiconductor.

Summary of the Invention

Problem to be Solved by the Invention

Incidentally, the technique disclosed in this patent publication, a top surface of an embedded layer needs to be flat in order to form a device function part on the embedded layer. This leads to issues of not only taking time to form the embedded layer, but also of difficulty in achieving sufficient reduction in the dislocation density.

Therefore, an object of the present disclosure is to provide a compound semiconductor layer stack that configures a base part in a light-emitting device, a method of forming the same, and a light-emitting device including such a compound semiconductor layer stack.

Means for Solving the Problem

The invention is defined in the independent claims. Optional embodiments of the invention are described in the dependent claims. A method of forming a compound semiconductor layer stack of the present invention to achieve the above described object is defined in claim 1.

A compound semiconductor layer stack of the present invention to achieve the above-described object is defined in claim 2.

A light-emitting device of the present invention to achieve the above-described object is defined in claim 7.

Brief Description of the Drawings

[FIG. 1] FIG. 1 is a schematic partial cross-sectional view of a compound semiconductor layer stack and a light-emitting device (specifically, a light emitting element, and more specifically, a semiconductor laser element) of Example 1.

[FIG. 2] FIGs. 2A, 2B, 2C and 2D are each a schematic partial end view of a base and the like for describing a method of forming the compound semiconductor layer stack of Example 1.

[FIG. 3] FIG. 3 is a schematic partial cross-sectional view of a compound semiconductor layer stack and a light-emitting device of Example 2.

[FIG. 4] FIG. 4 is a schematic partial cross-sectional view of a compound semiconductor layer stack and a light-emitting device of Example 3.

[FIG. 5] FIG. 5 is a schematic partial cross-sectional view of a compound semiconductor layer stack and a light-emitting device of Example 4.

[FIG. 6] FIG. 6 is a schematic partial cross-sectional view of a modification example of the compound semiconductor layer stack and the light-emitting device of Example 4.

[FIG. 7] FIG. 7 is a schematic partial cross-sectional view of another modification example of the compound semiconductor layer stack and the light-emitting device of Example 4.

[FIG. 8] FIG. 8 is a schematic view of a crystal structure of a hexagonal nitride semiconductor for describing a polar plane, a non-polar plane, and a semipolar plane in the nitride semiconductor crystal.

Modes for Carrying Out the Invention

Hereinafter, description is given of the present disclosure on the basis of examples with reference to the accompanying drawings, but the present disclosure is not limited to the examples, and various numerical values and materials in the examples are merely exemplary. It is to be noted that the description is given in the following order.

1. General Description Concerning Compound Semiconductor Layer Stack, Method of Forming Same, and Light-Emitting Device of Present Disclosure
2. Example 1 (Compound Semiconductor Layer Stack, Method of Forming Same, and Light-Emitting Device)
3. Example 2 (Modification Example of Example 1)
4. Example 3 (Modification Example of Example 1 to Example 2)
5. Example 4 (Modification Example of Example 1 to Example 3)
6. Others

<General Description Concerning Compound Semiconductor Layer Stack, Method of Forming Same, and Light-Emitting Device of Present Disclosure>

In a compound semiconductor layer stack of the present disclosure or a compound semiconductor layer stack of the present disclosure that configures a light-emitting device of the present disclosure (hereinafter, these compound semiconductor layer stacks may be collectively referred to as a "compound semiconductor layer stack, or the like of the present disclosure" in some cases), a mode is employed in which a first layer has a forward tapered sloped surface and a flat top surface. In addition, in a method of forming the compound semiconductor layer stack of the present disclosure, a mode is employed in which the first layer having the forward tapered sloped surface and the flat top surface is formed. Then, in these cases, a mode is employed in which a second layer is formed at least on the top surface of the first layer, or a mode is employed of forming the second layer at least on the top surface of the first layer. Further, a mode is employed in which the second layer is formed on the top surface and the sloped surface of the first layer, or a mode is employed of forming the second layer on the top surface and the sloped surface of the first layer. Furthermore, a mode is employed in which

$$T_{2\text{-}t} > T_{2\text{-}s}$$

is satisfied, where

$T_{2\text{-}t}$ denotes a thickness of a part of the second layer formed on the top surface of the first layer, and $T_{2\text{-}s}$ denotes a thickness of a part of the second layer formed on the sloped surface of the first layer. In the first layer having the forward tapered sloped surface and the flat top surface, a plane index of the top surface and a plane index of the sloped surface differ from each other. For this reason, as a result of a difference between a growth rate of the second layer on the top surface of the first layer and a growth rate of the second layer on the sloped surface of the first layer, the thickness $T_{2\text{-}t}$ of the part of the second layer on the top surface of the first layer and the thickness $T_{2\text{-}s}$ of the part of the second layer on the sloped surface of the first layer differ from each other, and $T_{2\text{-}t} > T_{2\text{-}s}$ holds. When the thickness $T_{2\text{-}s} \neq 0$ holds,

$$0.05 \leq T_{2\text{-}s}/T_{2\text{-}t} \leq 0.50$$

may hold as a relationship between the thickness $T_{2\text{-}t}$ and the thickness $T_{2\text{-}s}$, although this is not limitative. The formation of the first layer having the forward tapered sloped surface and the flat top surface is basically based on a growth condition where, for example, a migration length of gallium (Ga) atoms (e.g., a distance by which gallium atoms are able to move on a front surface of a base or the like) is shorter.

Examples of a distance from a front surface of the base to the top surface of the first layer (a thickness $T_1$ of the first layer) may include, but not limited to, $5 \times 10^{-8}$ m to $5 \times 10^{-7}$ m, and preferably $5 \times 10^{-8}$ m to $2 \times 10^{-7}$ m. Examples of the thickness $T_{2\text{-}t}$ may include, but not limited to, $1 \times 10^{-9}$ m to $2 \times 10^{-7}$ m, and preferably $1 \times 10^{-9}$ m to $1 \times 10^{-7}$ m. Examples of the thickness $T_{2\text{-}s}$ may include, but not limited to, $1 \times 10^{-9}$ m to $1 \times 10^{-7}$ m, and preferably $1 \times 10^{-9}$ m to $5 \times 10^{-8}$ m. Examples of a thickness $T_3$ of a third layer over the top surface of the first layer may include, but not limited to, $5 \times 10^{-8}$ m to $5 \times 10^{-7}$ m, and preferably $5 \times 10^{-8}$ m to $2 \times 10^{-7}$ m.

The compound semiconductor layer stack or the like of the present disclosure including the preferred mode described above may have a configuration in which a mask layer is formed on the base, and the first layer is formed on a part of the base not covered with the mask layer. In addition, the method of forming the compound semiconductor layer stack of the present disclosure including the preferred mode described above may have a configuration of forming a mask layer on the base prior to the formation of the first layer, and starting the formation of the first layer from the top of the part of the base not covered with the mask layer. In these cases, the mask layer may be configured by one type of a material selected from the group consisting of SiN, $SiO_2$, and $TiO_2$. The mask layer and the first layer make it possible to obtain a sea-island structure (the first layer corresponds to an island, and the mask layer corresponds to a sea). In other words, the mask layer having an opening is formed on the base, and the base is exposed to a bottom of the opening. A position where the opening is formed is substantially random. In addition, a planar shape of the opening is also substantially random. The formation of the first layer is not started from the top of the mask layer, but is started from an exposed surface of the base. Further, the first layer extends on the mask layer. Examples of a base coverage factor of the mask layer may be 10% to 99%. That is, the opening may be configured to account for 1% to 90% of the front surface of the base. Then, the first layer is started to be formed from the opening in this manner; as a result, it is possible to finally obtain the first layer having the forward tapered sloped surface and the flat top surface. Examples of the thickness of the mask layer may include, but not limited to, 0.1 nm to 5 nm. Forming, as a film, such a very thin mask layer on the base makes it possible to obtain the mask layer having the opening.

Alternatively, the compound semiconductor layer stack or the like of the present disclosure including the preferred mode described above may have a configuration in which the first layer is doped with impurities including Si or Mg, and a doping concentration is $1 \times 10^{19}$ cm$^{-3}$ or more. In addition, the method of forming the compound semiconductor layer stack of the present disclosure including the preferred mode described above may have a configuration of forming the first layer doped with the impurities including Si or Mg on the base; in this case, the doping concentration may be configured to be $1 \times 10^{19}$ cm$^{-3}$ or more. When the first layer is started to be formed on the base, a region with more impurities including Si and a region with less impurities including Si are formed on the front surface of the base. In the region with more impurities, it is difficult for the first layer to be formed similarly to a case where an SiN mask layer is formed, and thus the formation of the first layer is started from the region with less impurities. In addition, when the formation of the first layer is started while being doped with the impurities including Mg, a micro void (vacancy) is generated in the first layer, and the first layer is further grown from the micro void (vacancy) as a starting point. Specifying the doping concentration to be $1 \times 10^{19}$ cm$^{-3}$ or more makes it possible to securely cause these phenomena to occur. Thus, such a mode of forming the first layer makes it possible to finally obtain the first layer having the forward tapered sloped surface and the flat top surface without forming the mask layer.

The compound semiconductor layer stack or the like of the present disclosure including the preferred mode or the configuration described above may further have a configuration in which a multilayer structure (a superlattice structure) of an AlInGaN layer and an AlGaN layer are formed on the third layer. Examples of a composition of the AlInGaN layer may include $Al_{x2}In_{y2}Ga_{(1-x2-y2)}N$, and examples of a composition of the AlGaN layer may include $Al_{x3}Ga_{(1-x3)}N$, although not limited to these compositions. Examples of a thickness of the AlInGaN layer may include $1 \times 10^{-9}$ m to $1 \times 10^{-7}$ m, and examples of a thickness of the AlGaN layer may include $1 \times 10^{-9}$ m to $2 \times 10^{-7}$m.

The compound semiconductor layer stack or the like of the present disclosure including the preferred mode or the configuration described above may further have a configuration in which the base includes an InGaN layer; in this case, an atomic percentage of In atoms in the InGaN layer is preferably 0.5% or more and 30% or less. In addition, the method of forming the compound semiconductor layer stack of the present disclosure including the preferred mode or the structure described above may have a configuration of forming the InGaN layer on the base prior to the formation of the first layer; in this case, an atomic percentage of In atoms in the InGaN layer is preferably 0.5% or more and 30% or less. It is to be noted that the base includes the InGaN layer; specifically, an InGaN template substrate may be used in which a lattice-relaxed InGaN layer (corresponding to the base) is stacked on a sapphire substrate or a silicon substrate, or an InGaN substrate may be used.

In the compound semiconductor layer stack, a method of forming the same, and the light emitting device of the present disclosure, $0 \leq y1 < 1$ and $0 < y2 < 1$ are specified. That is, the first layer may include In, or may not include In.

In a case of y1 > 0,

$$0.1 \leq y1/y2 \leq 0.9$$

may hold, for example, as a relationship between y1 and y2. When there is too much In components in the first layer, it may be difficult, in some cases, to obtain the first layer having the forward tapered sloped surface and the flat top surface. The In components are preferably high in the second layer, which accelerates growth of the third layer in a direction parallel to the front surface of the base (may be referred to as a "lateral direction" for convenience, in some cases). The third layer does not include In, which accelerates the growth of the third layer in the lateral direction. Thus, as a result of the above, it is possible to obtain the third layer having a flat top surface even when the thickness of the third layer is thin.

In addition, $0 \leq x1 < 1$, $0 \leq x2 < 1$, $0 \leq x3 < 1$, $0 \leq y1 < 1$, and $0 < y2 < 1$ are specified, but it is preferable to satisfy:

$$0 \leq x1 \leq 0.20,$$

$$0 \leq x2 \leq 0.40,$$

$$0 \leq x3 \leq 0.40,$$

$$0 \leq y1 \leq 0.20,$$

and

$$0 < y2 \leq 0.20.$$

It is more preferable to satisfy:

$$0 \leq x1 \leq 0.10,$$

$$0 \leq x2 \leq 0.20,$$

$$0 \leq x3 \leq 0.40,$$

$$0 \leq y1 \leq 0.10,$$

and

$$0 < y2 \leq 0.10.$$

It may be possible to use: a GaN template substrate having a structure in which several μm of a GaN layer (corresponding to the base) is stacked on a sapphire substrate or a silicon substrate with a GaN low-temperature buffer layer interposed therebetween; an AlN template substrate having a structure in which several μm of an AlN layer (corresponding to the base) is stacked on a sapphire substrate or a silicon substrate with an AlN low-temperature buffer layer interposed therebetween; and the InGaN template substrate in which the above-described lattice-relaxed InGaN layer (corresponding to the base) is stacked on a sapphire substrate or a silicon substrate. Alternative examples of the base may include, in addition to the above-described InGaN substrate, a GaN substrate and an AlN substrate, and may further include a GaAs substrate, an SiC substrate, an alumina substrate, a ZnS substrate, a ZnO substrate, an AlN substrate, an LiMgO substrate, an LiGaO$_2$ substrate, an MgAl$_2$O$_4$ substrate, and an InP substrate.

A front surface of a substrate including a Group III-V compound semiconductor may be configured by Group III atoms or may be configured by Group V atoms. The front surface (principal plane) of the base including the Group III-V compound semiconductor (specifically, GaN-based compound semiconductor) may be configured by: a c-plane being a {0001} plane; an a-plane being a {11-20} plane; an m-plane being a {1-100} plane; a {1-102} plane; a {11-2n} plane including a {11-24} plane or a {11-22} plane; a {10-11} plane; a {10-12} plane; a {20-21} plane; a {1-101} plane; a {2-201} plane; or a {11-21} plane. It is to be noted that, for example, notations of a crystal plane exemplified below:

{$hk\bar{i}l$} plane; and
{$h\bar{k}il$} plane
in the hexagonal system are represented as a {hk-il} plane and a {h-kil} plane, for convenience, in the present specification.

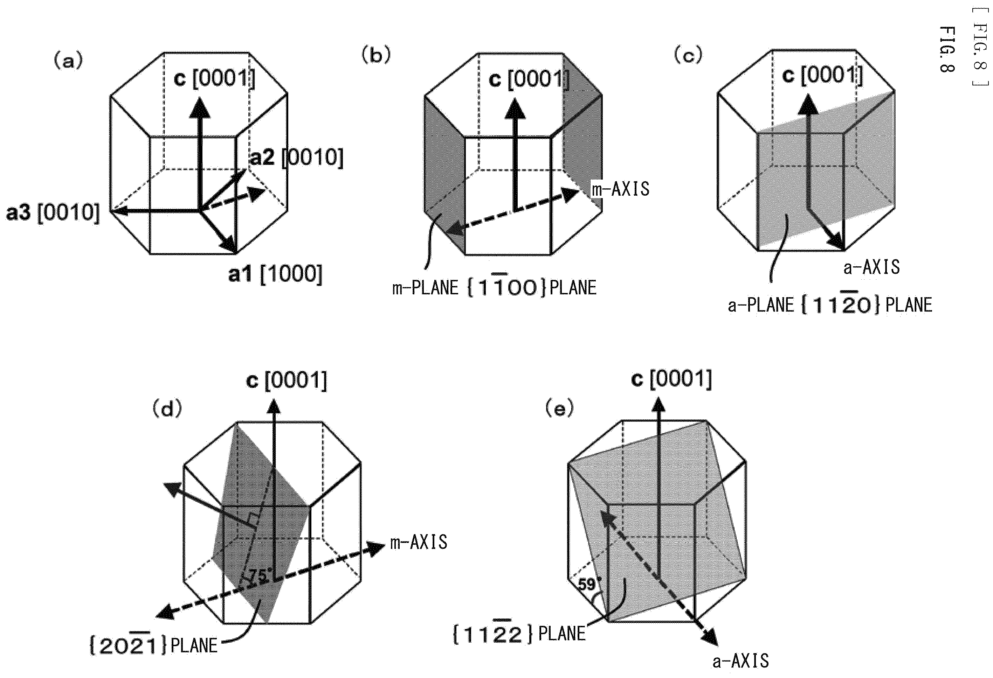

Description is given below of a polar plane, a non-polar plane and a semipolar plane in a nitride semiconductor crystal, with reference to (a) to (e) of FIG. 8. (a) of FIG. 8 is a schematic view of a crystal structure of a hexagonal nitride semiconductor. (b) of FIG. 8 is a schematic view of the m-plane being a non-polar plane, i.e., the {1-100} plane, and the m-plane indicated by a gray planar surface is a plane perpendicular to a m-axis direction. (c) of FIG.8 is a schematic view of the a-plane being a non-polar plane, i.e., the {11-20} plane, and the a-plane indicated by a gray planar surface is a plane perpendicular to an a-axis direction. (d) of FIG. 8 is a schematic view of the {20-21} plane being a semipolar plane. A [20-21] direction perpendicular to the {20-21} plane indicated by a gray planar surface is inclined by 75 degrees from a c-axis to the m-axis direction. (e) of FIG. 8 is a schematic view of the {11-22} plane being a semipolar plane. A [11-22] direction perpendicular to the {11-22} plane indicated by a gray planar surface is inclined by 59 degrees from the c-axis to the a-axis direction. Table 1 below exhibits an angle formed between a plane orientation of each of various crystal planes and the c-axis. The {11-2n} plane such as the {11-21} plane, the {11-22} plane, or the {11-24} plane, the {1-101} plane, the {1-102} plane, or a {1-103} plane is a semipolar plane.

<Table 1>

| Plane Orientation | Angle Formed with respect to c-Axis (Degree) |
|---|---|
| {1-100} | 90.0 |
| {11-20} | 90.0 |
| {20-21} | 75.1 |
| {11-21} | 72.9 |
| {1-101} | 62.0 |
| {11-22} | 58.4 |
| {1-102} | 43.2 |
| {1-103} | 32.0 |

Examples of the light-emitting device of the present disclosure including the various preferred modes and the configurations described above may include a semiconductor optical device such as an edge-emitting semiconductor laser element, an edge-emitting super luminescent diode (SLD), or a semiconductor optical amplifier. The semiconductor optical amplifier does not convert an optical signal into an electric signal, but directly amplifies the optical signal in a state of light; the semiconductor optical amplifier has a laser-structure with a resonator effect being eliminated as much as possible, and amplifies incident light on the basis of an optical gain of the semiconductor optical amplifier. The semiconductor laser element optimizes an optical reflectance at a first edge face (light-exiting edge face) and an optical reflectance at a second edge face (light-reflecting edge face) to thereby configure a resonator, allowing the light to be emitted from the first edge face. Alternatively, an external resonator may be disposed. Meanwhile, the super luminescent diode sets the optical reflectance at the first edge face to a very low value, and sets the optical reflectance at the second edge face to a very high value to allow light generated in an active layer (light-emitting layer) to be reflected by the second edge face and to be emitted from the first edge face, without configuring the resonator. In the semiconductor laser element and the super luminescent diode, a non-reflective coating layer (AR) or a low reflective coating layer is formed on the first edge face, and a high reflective coating layer (HR) is formed on the second edge face. In addition, the semiconductor optical amplifier sets each optical reflectance at the first edge face and the second edge face to a very low value, and amplifies light incident from the second edge face to emit the amplified light from the first edge face, without configuring the resonator. The structure of the light-emitting device of the present disclosure is also applicable to a light-emitting device (semiconductor optical device) such as a surface-emitting laser element (vertical-cavity laser; also referred to as VCSEL) and a light emitting diode (LED). In addition, the configuration and the structure of the light-emitting device of the present disclosure is applicable to a switching element such as a MOSFET or a HEMT, a current amplifying element, a high frequency generating element, or the like.

Examples of a compound semiconductor configuring a first compound semiconductor layer, the active layer (light-emitting layer), and a second compound semiconductor layer may include AlInGaN-based compound semiconductors such as GaN, AlGaN, InGaN, and AlInGaN. Further, these compound semiconductors may contain, when desired, boron (B) atoms, thallium (Tl) atoms, arsenic (As) atoms, phosphorus (P) atoms, or antimony (Sb) atoms. Examples of a formation method (film formation method) of these layers or a formation method (film formation method) of the first layer, the second layer and the third layer may include a metalorganic chemical vapor deposition method (MOCVD method, MOVPE method), a molecular beam epitaxy method (MBE method), a metalorganic molecular beam epitaxy method (MOMBE method), a hydride vapor-phase epitaxial method (HVPE method) in which a halogen contributes to transportation or reaction, a plasma-assisted physical vapor deposition method (PPD method), an atomic layer deposition method (ALD method, atomic layer deposition method), and a sputtering method. Here, examples of an organic gallium source gas in the MOCVD method may include a trimethylgallium (TMG) gas and a triethylgallium (TEG) gas, and examples of a nitrogen source gas include an ammonia gas and a hydrazine gas. In addition, in a case where aluminum (Al) or indium (In) is contained as a constituent atom of an AlInGaN-based compound semiconductor layer, a trimethylaluminum (TMA) gas may be used as an Al source, and a trimethylindium (TMI) gas may be used as an In source. Further, a monosilane gas ($SiH_4$ gas) may be used as an Si source, and a cyclopentadienyl magnesium gas, methylcyclopentadienyl magnesium or biscyclopentadienyl magnesium ($Cp_2Mg$) may be used as an Mg source. In a case where a stripe structure is formed from a stacked emitter structure including the first compound semiconductor layer, the active layer, and the second compound semiconductor layer, examples of an etching method of the stacked emitter structure to form the stripe structure may include a combination of a lithography technique and a wet etching technique and a combination of a lithography technique and a dry etching technique. The stacked emitter structure is formed on the compound semiconductor layer stack, and has a structure in which the first compound semiconductor layer, the active layer, and the second compound semiconductor layer are stacked from side of the compound semiconductor layer stack, as described above.

The active layer (light-emitting layer) desirably has a quantum well structure. Specifically, the active layer may have a single quantum well structure (SQW structure), or may have a multiple quantum well structure (MQW structure). The active layer having the quantum well structure has a structure in which at least one layer of a well layer and at least one layer of a barrier layer are stacked; however, examples of a combination of (a compound semiconductor configuring the well layer and a compound semiconductor configuring the barrier layer) may include (InGaN, GaN), (InGaN, AlInGaN), (InGaN, InGaN) [provided that a composition of InGaN configuring the well layer and a composition of InGaN configuring the barrier layer differ from each other]. Further, the barrier layer may be configured by a group of layers having a plurality of compositions.

In order to impart an n-type electrically-conductive type to the first compound semiconductor layer and to impart a p-type electrically-conductive type to the second compound semiconductor layer, impurities may be introduced into each of the first compound semiconductor layer and the second compound semiconductor layer. Examples of n-type impurities to be added to the compound semiconductor layer may include silicon (Si), sulfur (S), selenium (Se), germanium (Ge), tellurium (Te), tin (Sn), carbon (C), titanium (Ti), oxygen (O) and palladium (Pd), and examples of p-type impurities may include zinc (Zn), magnesium (Mg), carbon (C), beryllium (Be), cadmium (Cd), calcium (Ca), and barium (Ba).

The first compound semiconductor layer is electrically coupled to a first electrode, and the second compound semiconductor layer is electrically coupled to a second electrode. The second electrode may be in a form of a monolayer configuration or a multilayer configuration (e.g., a palladium layer/platinum layer stack structure in which a palladium layer is in contact with the second compound semiconductor layer, or a palladium layer/nickel layer stack structure in which the palladium layer is in contact with the second compound semiconductor layer) including at least one type of a metal (including an alloy) selected from the group consisting of, for example, palladium (Pd), nickel (Ni), platinum (Pt), gold (Au), cobalt (Co), and rhodium (Rh), or may be in a form of a transparent electrically-conductive material such as ITO. The first electrode desirably has a monolayer structure or a multilayer structure including at least one type of a metal (including an alloy) selected from the group consisting of, for example, gold (Au), silver (Ag), palladium (Pd), platinum (Pt), nickel (Ni), aluminum (Al), titanium (Ti), tungsten (W), vanadium (V), chromium (Cr), copper (Cu), zinc (Zn), tin (Sn), and indium (In), and examples thereof may include Ti/Au, Ti/Al, Ti/Pt/Au, Ti/Al/Au, Ti/Pt/Au, Ni/Au, Ni/Au/Pt, Ni/Pt, Pd/Pt, and Ag/Pd. It is to be noted that the former layer of the virgule "/" in the multilayer configuration is positioned closer to side of the active layer. The same applies to the following description. The first electrode is electrically coupled to the first compound semiconductor layer; however, a mode in which the first electrode is formed on the first compound semiconductor layer and a mode in which the first electrode is coupled to the first compound semiconductor layer via an electrically-conductive material layer or the compound semiconductor layer stack may be included. The first electrode and the second electrode may be formed, as films, by, for example, a PVD method such as a vacuum vapor deposition method or a sputtering method.

A pad electrode may be provided on the first electrode or the second electrode for electrical coupling to an external electrode or a circuit. The pad electrode desirably has a monolayer configuration or a multilayer configuration including at least one type of a metal (including an alloy) selected from the group consisting of Ti (titanium), Aluminum (Al), Pt (platinum), Au (gold), Ni (nickel), and Pd (palladium). Alternatively, the pad electrode may also have a multilayer configuration as exemplified in the multilayer configuration of Ti/Pt/Au, the multilayer configuration of Ti/Au, a multilayer configuration of Ti/Pd/Au, the multilayer configuration of Ti/Pd/Au, a multilayer configuration of Ti/Ni/Au, and a multilayer configuration of Ti/Ni/Au/Cr/Au.

In addition, in a case where the second electrode is formed on or over the second compound semiconductor layer having a p-type electrically-conductive type, a transparent electrically-conductive material layer may be formed between the second electrode and the second compound semiconductor layer. Examples of the transparent electrically-conductive material configuring the transparent electrically-conductive material layer may include indium-tin oxide (including ITO, Indium Tin Oxide, Sn-doped $In_2O_3$, crystalline ITO and amorphous ITO), indium-zinc oxide (IZO, Indium Zinc Oxide), IFO (F-doped $In_2O_3$), tin oxide ($SnO_2$), ATO (Sb-doped $SnO_2$), FTO (F-doped $SnO_2$), zinc oxide (including ZnO, Al-doped ZnO, and B-doped ZnO), and TNO (Nb-doped $TiO_2$).

The light-emitting device of the present disclosure is applicable, for example, to a display apparatus. That is, examples of such a display apparatus may include a projector apparatus, an image display apparatus and a monitor apparatus each provided with the light-emitting device of the present disclosure as a light source, and a head-mounted display (HMD), a head-up display (HUD) and various types of lighting provided with the light-emitting device of the present disclosure as a light source. In addition, the light-emitting device of the present disclosure may be used as a light source of a microscope. However, the light-emitting device of the present disclosure is not limited to these fields.

[Example 1]

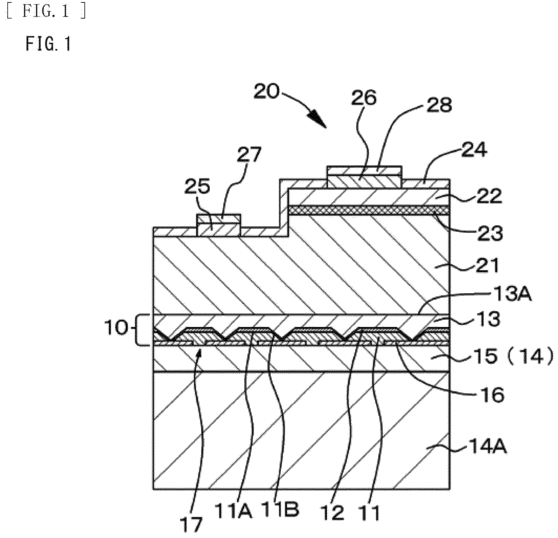

Example 1 relates to the compound semiconductor layer stack and the method of forming the same of the present disclosure, and to the light-emitting device of the present disclosure. FIG. 1 illustrates a schematic partial cross-sectional view of a compound semiconductor layer stack and a light-emitting device (specifically, a light-emitting element or a semiconductor optical device, and more specifically, a semiconductor laser element) of Example 1.

A compound semiconductor layer stack 10 of Example 1 includes:

a first layer 11 being formed on a base 14 and including an island-shaped $Al_{x1}In_{y1}Ga_{(1-x1-y1)}N$;
a second layer 12 being formed on the first layer 11 and including $Al_{x2}In_{y2}Ga_{(1-x2-y2)}N$; and
a third layer 13 being formed on an entire surface including a top of the second layer 12, the third layer 13 including $Al_{x3}Ga_{(1-x3)}N$, with the third layer 13 having a top surface 13A that is flat, provided that the following hold true: $0 \leq x1 < 1$; $0 \leq x2 < 1$; $0 \leq x3 < 1$; $0 \leq y1 < 1$; and $0 < y2 < 1$.

The light-emitting device of Example 1 includes, for example, an edge-emitting semiconductor laser element, and includes

a compound semiconductor layer stack formed on the base 14,
a first compound semiconductor layer 21 formed on the compound semiconductor layer stack 10,
an active layer 23 formed on the first compound semiconductor layer 21,
a second compound semiconductor layer 22 formed on the active layer 23,
a second electrode 26 electrically coupled to the second compound semiconductor layer 22, and

a first electrode 25 electrically coupled to the first compound semiconductor layer 21, and the compound semiconductor layer stack includes the compound semiconductor layer stack 10 of Example 1.

The semiconductor laser element of Example 1 emits light having a wavelength of, but not limited to, 440 nm or more and 600 nm or less, and preferably 495 nm or more and 570 nm or less.

In addition, the first layer 11 has a forward tapered sloped surface 11B and a flat top surface 11A. Here, the second layer 12 is formed at least on the top surface 11A of the first layer 11. In the illustrated example, the second layer 12 is formed on the top surface 11A and the sloped surface 11B of the first layer 11; however, in some cases, the second layer 12 is formed only on the top surface 11A of the first layer 11. When $T_{2\text{-}t}$ denotes a thickness of a part of the second layer 12 formed on the top surface 11A of the first layer 11, and $T_{2\text{-}s}$ denotes a thickness of a part of the second layer 12 formed on the sloped surface 11B of the first layer 11,

$$T_{2\text{-}t} > T_{2\text{-}s}$$

is satisfied.

The top surface 11A of the first layer 11 is configured by a (0001) plane, and the sloped surface of 11B is configured by a (11-22) plane. For this reason, a growth rate of the second layer 12 on the top surface 11A of the first layer 11 and a growth rate of the second layer 12 on the sloped surface 11B of the first layer 11 differ from each other. Specifically, the growth rate of the second layer 12 on the sloped surface 11B of the first layer 11 is slower than the growth rate of the second layer 12 on the top surface 11A of the first layer 11. As a result, the thickness $T_{2\text{-}t}$ of the part of the second layer 12 on the top surface 11A of the first layer 11 and the thickness $T_{2\text{-}s}$ of the part of the second layer 12 on the sloped surface 11B of the first layer 11 differ from each other, and $T_{2\text{-}t} > T_{2\text{-}s}$ holds. When the thickness $T_{2\text{-}s} \neq 0$ holds,

$$0.05 \leq T_{2\text{-}s}/T_{2\text{-}t} \leq 0.50$$

may hold as a relationship between the thickness $T_{2\text{-}t}$ and the thickness $T_{2\text{-}s}$, although this is not limitative.

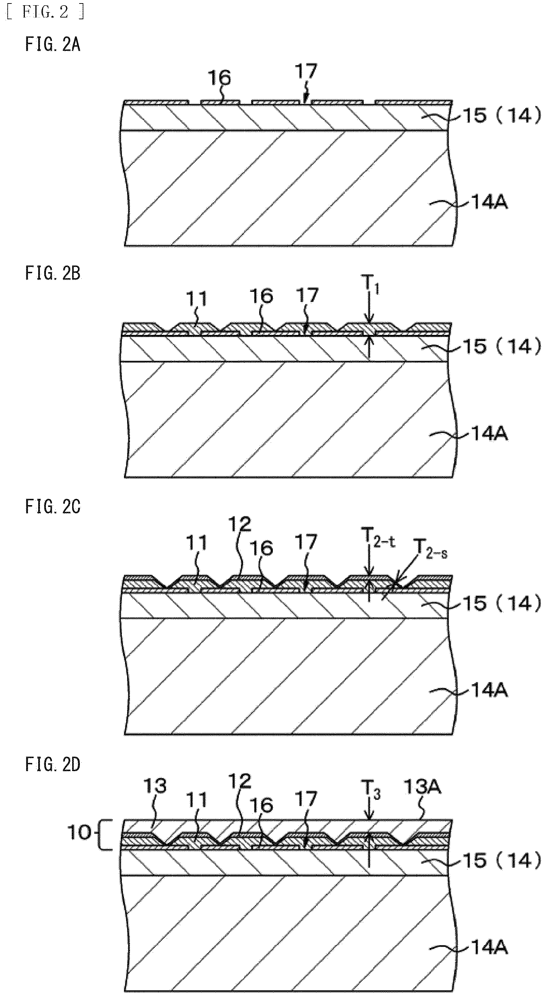

Examples of a distance from a front surface of the base 14 to the top surface 11A of the first layer 11 (thickness $T_1$ of the first layer 11 in FIG. 2B) may include, but not limited to, 50 nm to 0.5 $\mu$m. Examples of the thickness $T_{2\text{-}t}$ (see FIG. 2C) may include, but not limited to, 1 nm to 0.2 $\mu$m. Examples of the thickness $T_{2\text{-}s}$ may include, but not limited to, 1 nm to 0.1 $\mu$m. Examples of the thickness $T_3$ (see FIG. 2D) of the third layer 13 over the top surface 11A of the first layer 11 may include, but not limited to, 50 nm to 0.5 $\mu$m. In Example 1, specifically, the following were set:

$T_1$ = 100 nm;
$T_{2\text{-}t}$ = 20 nm;
$T_{2\text{-}s}$ = 2 nm; and
$T_3$ = 200 nm.

Further, in Example 1, a mask layer 16 is formed on the base 14, and the first layer 11 is formed on a part of the base 14 not covered with the mask layer 16. The mask layer 16 includes SiN, for example. Examples of a thickness of the mask layer 16 may include, but not limited to, 0.1 nm to 5 nm. The mask layer 16 has an opening 17.

In Example 1,

$$0.1 \leq y1/y2 \leq 0.9$$

is satisfied. Specifically, the following were set:

x1 = 0;
x2 = 0;
x3 = 0;
y1 = 0.03; and
y2 = 0.09.

A GaN template substrate was used having a structure in which several $\mu$m of a GaN layer (collectively denoted by a reference numeral 15 in the drawing) is stacked on a sapphire substrate or a silicon substrate (collectively denoted by a reference numeral 14A in the drawing) with a GaN low temperature buffer layer interposed therebetween. The GaN layer 15 exposed to the opening 17 corresponds to the base 14, and the front surface (exposed surface) of the base 14 is configured by the (0001) plane. In some cases, the GaN substrate may also be used as the base 14

The first compound semiconductor layer 21, the active layer (light-emitting layer) 23 and the second compound semiconductor layer 22 that configure the stacked emitter structure were set as exemplified in Table 2 below.

<Table 2>

Second Compound Semiconductor Layer 22
Contact Layer (Mg-Doped) including p-type GaN.
Second Clad Layer (Mg-Doped)
p-type AlGaN having a thickness 0.2 $\mu$m to 0.4 $\mu$m
Active Layer 23 (Total Thickness: 0.1 $\mu$m to 0.3 $\mu$m)
Second Light Guide Layer including non-doped GaInN.
Quantum-Well Active Layer (Well-layer: InGaN/ Barrier Layer: InGaN)
First Light Guide Layer including non-doped GaInN.
First Compound Semiconductor Layer 21 First Clad Layer (Si-Doped)
n-type AlGaN having a thickness 0.5 $\mu$m to 1. 5 $\mu$m

Hereinafter, description is given of a method of forming the compound semiconductor layer stack of Example 1 with reference to FIGs. 2A, 2B, 2C, and 2D, which are each a schematic partial end view of a base and the like.

[Step-100]

First, a GaN template substrate is prepared which has a structure in which several $\mu$m of the GaN layer 15 is stacked on a sapphire substrate or a silicon substrate 14A with a GaN low-temperature buffer layer interposed therebetween. Then, the mask layer 16 is formed on the base 14 on the basis of the MOCVD method (see FIG. 2A). Specifically, a film formation temperature of the mask layer 16 including SiN may be set to about 900°C to 1100°C. An $SiH_4$ gas may be used as a raw material of Si, and $NH_3$ may be used as a raw material of N. For example, forming the mask layer 16 having a thickness of 0.26 nm allows for natural and random formation of the opening 17. That is, a formation positions of the opening 17 is random. In addition, a planar shape of the opening 17 is also random.

[Step-110]

Next, the first layer 11 including an island-shaped $Al_{x1}In_{y1}Ga_{(1-x1-y1)}N$ is formed on the base 14 on the basis of the MOCVD method. Specifically, the first layer 11 of a three-dimensional structure having the forward tapered sloped surface 11B and the flat top surface 11A is formed. The first layer 11 is formed on the part of the base 14 not covered with the mask layer 16. That is, the formation of the first layer 11 is started from the top of the base 14 exposed to a bottom of the opening 17 of the mask layer 16. As the formation of the first layer 11 proceeds, the first layer 11 extends on the mask layer 16. Then, the first layer 11 of a three-dimensional structure having the forward tapered sloped surface 11B and the flat top surface 11A is finally formed (see FIG. 2B). It is sufficient to appropriately select a growth temperature as well as a growth pressure, a composition ratio between a gas source containing group III atoms and a gas source containing group V atoms to be used for the growth of the first layer 11, and a growth rate to allow for the formation of the first layer 11 having the forward tapered sloped surface 11B and the flat top surface 11A. Examples of the growth temperature of the first layer 11 may include 700°C to 1100°C.

[Step-120]

Then, the second layer 12 including $Al_{x2}In_{y2}Ga_{(1-x2-y2)}N$ is formed at least on the first layer 11 on the basis of the MOCVD method (see FIG. 2C). Specifically, the second layer 12 is formed on the top surface 11A and the sloped surface 11B of the first layer 11. Because of a difference between plane indices of the forward tapered sloped surface 11B and the flat top surface 11A of the first layer 11, the growth rate of the second layer 12 on the top surface 11A of the first layer 11 is faster than the growth rate of the second layer 12 on the sloped surface 11B of the first layer 11, thus making it possible to achieve $T_{2-t} > T_{2-s}$. That is, the top surface 11A of the first layer 11 is configured by the (0001) plane, and the sloped surface 11B is configured by the {11-22} plane [provided that n is an integer of zero to four; specifically, the (11-22) plane, for example]. Accordingly, in the second layer 12 grown on the sloped surface 11B, In atoms are poorly incorporated, and thus the growth rate of the second layer 12 on the sloped surface 11B of the first layer 11 is slower than the growth rate of the second layer 12 on the top surface 11A of the first layer 11.

Examples of the growth temperature of the second layer 12 may include 700°C to 900°C.

[Step-130]

Subsequently, the third layer 13 including $Al_{x3}Ga_{(1-x3)}N$ is formed on an entire surface including a top of the second layer 12 on the basis of the MOCVD method (see FIG. 2D). In epitaxial growth of the third layer 13, a growth temperature as well as a growth pressure, a composition ratio between a gas source containing group III atoms and a gas source containing group V atoms to be used for the growth of the third layer 13, and a growth rate are appropriately selected. Further, a slow growth rate in a thickness direction of the third layer 13 containing no In atoms on the second layer 12 containing In atoms is utilized to accelerate the growth of the third layer 13 in the lateral direction. This makes it possible to obtain the third layer 13 having a flat top surface despite thin thickness. In addition, dislocation annihilation is accelerated, thus making it possible to achieve a reduction in threading dislocation density. Specifically, the growth temperature of the third layer 13 may be set higher than that of the first layer 11, and the growth pressure thereof may be set lower. Examples of the growth temperature of the third layer 13 may include 700°C to 1100°C.

For example, the currently available structure including the first layer of AlGaN and the third layer of GaN formed on the first layer without forming the second layer requires formation of the third layer having a film thickness of several $\mu$m to obtain such flatness as to obtain atomic steps. Meanwhile, in Example 1, even when the thickness $T_3$ of the third layer 13 is about 200 nm to 300 nm, it is possible to obtain such flatness as to obtain the atomic steps in the third layer 13, and it is possible to reduce the threading dislocation density by one to two orders of magnitude as compared with the currently available structure.

[Step-140]

Thereafter, the first compound semiconductor layer 21, the active layer 23, and the second compound semiconductor layer 22 are sequentially formed on the third layer 13 on the basis of the MOCVD method. Next, an etching mask is formed on the second compound semiconductor layer 22, and the etching mask is used to etch the second compound semiconductor layer 22 and the active layer 23 in the thickness direction, for example, on the basis of the RIE method. Further, the first compound semiconductor layer 21 is partially etched in the thickness direction to thereby form a stripe structure 20, and thereafter the etching mask is removed. Subsequently, an insulating layer 24 is formed all over, and a part of the insulating layer 24 positioned on a top surface of the second compound semiconductor layer 22 is removed. Then, the second electrode 26 is formed on the exposed second compound semiconductor layer 22. In addition, a portion of the first compound semiconductor layer 21 is exposed, and the first electrode 25 is formed on the exposed portion. Further, pad electrodes 27 and 28 are formed on the first electrode 25 and the second electrode 26, respectively.

[Step-150]

Subsequently, cleaving the compound semiconductor layer stack and the stacked emitter structure allows for formation of a first edge face and a second edge face. Then, a coating layer of each of the first edge face and the second edge face is formed. Thereafter, a terminal or the like is formed on the basis of a well-known method to couple an electrode to an external circuit or the like, and packaging or sealing is performed to thereby completing the light-emitting device of Example 1.

As has been described above, in the compound semiconductor layer stack and the method of forming the same of Example 1 as well as in the light-emitting device (including an electronic device) of the present disclosure, the compound semiconductor layer stack has the structure of including the first layer of a three-dimensional structure, the second layer formed on the first layer and having a composition different from that of the first layer, and the third layer formed on the second layer and having a composition different from that of the second layer, thus making it possible to obtain the third layer having a flat top surface despite thin thickness. Accordingly, it is possible to considerably reduce time required to form the compound semiconductor layer stack. In addition, in the currently available technique, forming compound semiconductor layers having different lattice constants on the compound semiconductor layer results in higher threading dislocation density, whereas, in Example 1, as a result of the acceleration of the growth of the third layer growth in the lateral direction on the second layer, the dislocation annihilation is more likely to occur, thus making it possible to achieve a reduction in the threading dislocation density. Then, consequently, the light-emitting device (including an electronic device) makes it possible to achieve a reduction in the leak current and an improvement in reliability. Further, the light-emitting element makes it possible to achieve an improvement in luminous efficiency, in addition to the reduction in the leak current and the improvement in the reliability.

[Example 2]

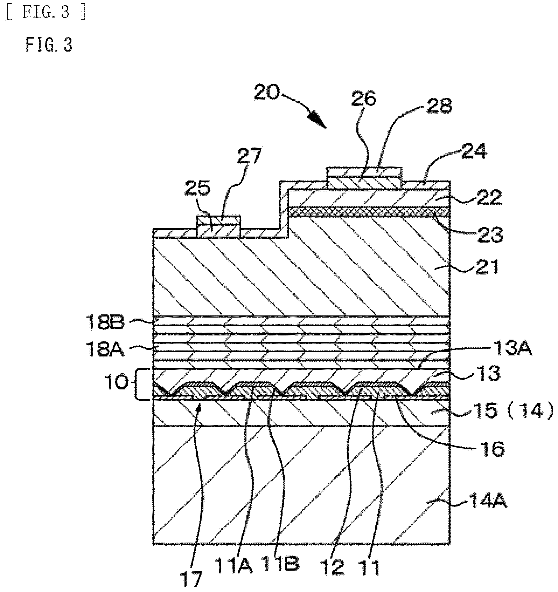

Example 2 is a modification example of Example 1. As FIG. 3 illustrates a compound semiconductor layer stack and a light-emitting device of Example 2 in a schematic partial cross-sectional view, a multilayer structure (superlattice structure) 18 of an AlInGaN layer 18A having a thickness of 20 nm and the layer number of ten and an AlGaN layer 18B having a thickness 20 nm and the layer number of ten is formed on the third layer 13, in the examples 2. Forming the multilayer structure (superlattice structure) 18 on the third layer 13 in this manner makes it possible to further reduce the thickness of the third layer 13. In addition, the AlGaN layer 18B not containing In atoms to be formed on the AlInGaN layer 18A containing In atoms is slow to grow in the thickness direction due to the presence thereof, which slowness is utilized to accelerate the growth of the AlGaN layer 18B in the lateral direction, thereby making it possible to obtain a more flat surface as a base layer of the stacked emitter structure.

Except for the points described above, configurations and structures of the compound semiconductor layer stack and the light-emitting device of Example 2 may be similar to the configurations and the structures of the compound semiconductor layer stack and the light-emitting device of Example 1, and thus detailed descriptions thereof are omitted.

[Example 3]

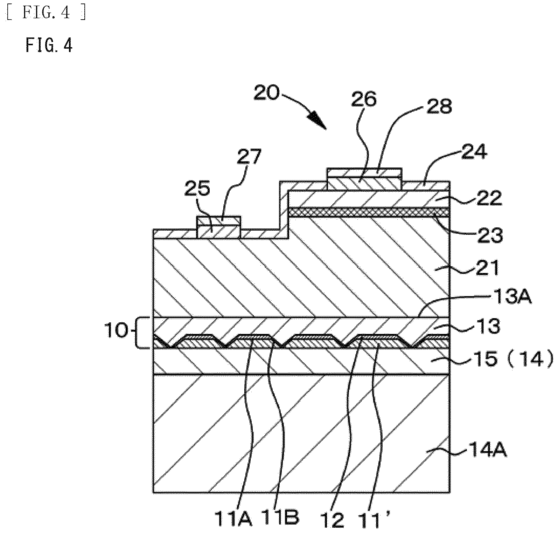

Example 3 is a modification example of Example 1 to Example 2. As FIG. 4 illustrates a compound semiconductor layer stack and a light-emitting device of Example 3 in a schematic partial cross-sectional view, the mask layer 16 is not formed in Example 3, and a first layer 11' is doped with impurities including Si or Mg, with a doping concentration being $1 \times 10^{19}$ cm$^{-3}$ or more. When the first layer 11' is started to be formed on the base 14, a region with more impurities including Si and a region with less impurities including Si are formed on the front surface of the base 14. Then, an anti-surfactant effect causes the first layer 11' not to be easily formed in the region with more impurities, but causes the first layer 11' to be formed from the region with less impurities. In addition, when the first layer 11' is started to be formed while being doped with impurities including Mg, a micro void (vacancy) is generated in the first layer 11', and the first layer 11' is further grown from the micro void (vacancy) as a starting point. Specifying the doping concentration to be $1 \times 10^{19}$ cm$^{-3}$ or more makes it possible to securely cause these phenomena to occur. Then, such a mode of formation of the first layer 11' makes it possible to finally obtain the first layer 11' having the forward tapered sloped surface 11B and the flat top surface 11A without forming the mask layer.

Except for the points described above, configurations and structures of the compound semiconductor layer stack and the light-emitting device of Example 3 may be similar to the configurations and the structures of the compound semiconductor layer stacks and the light-emitting devices of Example 1 to Example 2, and thus detailed descriptions thereof are omitted.

It is to be noted that appropriate selection of a growth temperature as well as a growth pressure, a composition ratio between a gas source containing group III atoms and a gas source containing group V atoms to be used for the growth of the first layer 11', and a growth rate also makes it possible to obtain the first layer 11' having the forward tapered sloped surface 11B and the flat top surface 11A. Specifically, the growth temperature may be set to a low temperature equal to or less than 1000°C, and the growth pressure may set high. That is, for example, the growth temperature of the first layer 11' is first set to 700°C or less to grow the first layer 11' by several nm to several tens of nm, and then the growth temperature of the first layer 11' is set to 700°C or more, thereby making it possible to obtain the first layer 11' having the forward tapered sloped surface 11B and the flat top surface 11A.

[Example 4]

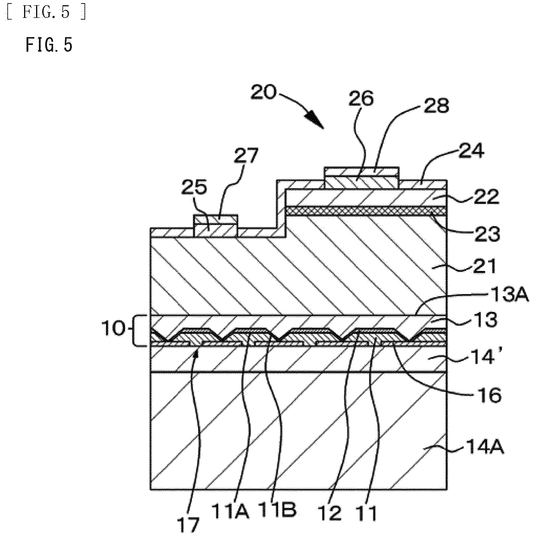

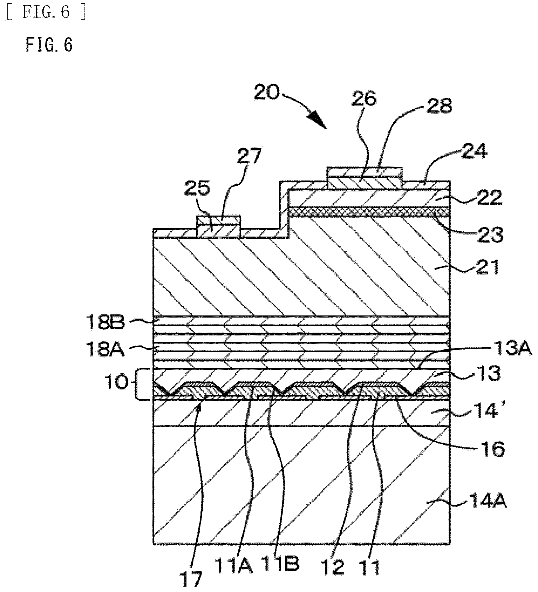

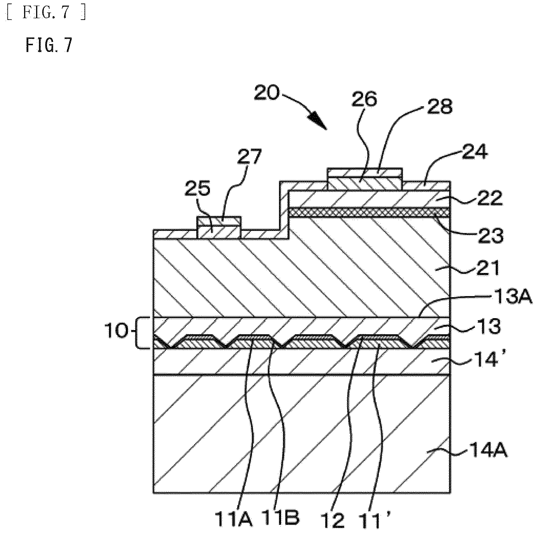

Example 4 is a modification example of Example 1 to Example 3. As FIGs. 5, 6 and 7 illustrate a compound semiconductor layer stack and a light-emitting device of Example 4 in a schematic partial cross-sectional view, the base 14' includes an InGaN layer in Example 4. Specifically, an InGaN template substrate is used in which a lattice-relaxed InGaN layer (corresponding to the base) is stacked on the sapphire substrate or the silicon substrate 14A. A thickness of the InGaN layer corresponding to the base 14' is, for example, 1 $\mu$m or less. Then, in this case, an atomic percentage of In atoms in the InGaN layer is preferably 0.5% or more and 30% or less, and is specifically set to 10 atomic%. In addition, the base 14' may be configured by a multilayer structure including the InGaN layer, the AlGaN layer, the GaN layer, and the like having different In compositions. It is to be noted that FIG. 5 illustrates a modification example of Example 1, FIG. 6 illustrates a modification example of Example 2, and FIG. 7 illustrates a modification example of Example 3. It is to be noted that the InGaN substrate may also be used as the base 14', and such a configuration is also included in the configuration in which "the base includes the InGaN layer".

Except for the points described above, configurations and structures of the compound semiconductor layer stack and the light-emitting device of Example 4 may be similar to the configurations and the structures of the compound semiconductor layer stacks and the light-emitting devices of Example 1 to Example 3, and thus detailed descriptions thereof are omitted.

Although the description has been given hereinabove of the present disclosure on the basis of preferred examples, the present disclosure is not limited to these examples. The configurations and the structures of the compound semiconductor layer stacks and the devices and the method of forming the compound semiconductor layer stack

**EP 3 958 333 B1**

described in the examples are merely illustrative, and may be modified where appropriate. The light-emitting device has been described solely as a semiconductor-laser element; however, alternatively, the light-emitting diode (LED), the super luminescent diode (SLD), or the semiconductor optical amplifier may also be employed as the light-emitting device. It is to be noted that configurations and structurers of the SLD and the semiconductor optical amplifier may be substantially the same as the configurations and the structurers of the light-emitting devices (semiconductor optical devices) described in Example 1 to Example 4, except for a difference in the optical reflectances in the light-exiting edge face and the light-reflecting edge face.

In the examples, the stripe structure 20 has a linearly extending shape, but is not limited thereto; the stripe structure 20 may not only extend at a constant width, but also have a tapered shape or a flared shape. Specifically, for example, there may be a configuration of being spread gently in a tapered manner, monotonically, from the light-exiting edge face toward the light-reflecting edge face, or a configuration of being first spread to exceed the maximum width and then being narrowed, from the light-exiting edge face toward the light-reflecting edge face.

[Reference Numerals List]

10 compound semiconductor layer stack
11, 11' first layer
11A top surface of first layer
11B sloped surface of first layer
12 second layer
13 third layer
13A top surface of third layer
14, 14' base
14A sapphire substrate or silicon substrate
15 GaN low temperature buffer layer and GaN layer
16 mask layer
17 opening of mask layer
18 multilayer structure (superlattice structure)
18A AlInGaN layer
18B AlGaN layer
20 ridge stripe structure
21 first compound semiconductor layer
22 second compound semiconductor layer
23 active layer (light-emitting layer)
25 first electrode
26 second electrode
27, 28 pad electrode.

**Claims**

1. A method of forming a compound semiconductor layer stack, the method comprising:

forming, on a base (14, 14'), a first layer (11, 11') including an island-shaped $Al_{x1}In_{y1}Ga_{(1-x1-y1)}N$;
forming, on the first layer (11, 11'), a second layer (12) including $Al_{x2}In_{y2}Ga_{(1-x2-y2)}N$; and
forming, on an entire surface of the second layer (12) including a top of the second layer (12), a third layer (13) including $Al_{x3}Ga_{(1-x3)}N$, the third layer having a top surface (13A) that is flat,
provided that the following hold true:

$$0 \le x1 < 1;\ 0 \le x2 < 1;\ 0 \le x3 < 1;\ 0 \le y1 < 1;\ \text{and}\ 0 < y2 < 1,$$

wherein the first layer (11, 11') having a forward tapered sloped surface (11B) and a flat top surface (11A) is formed,
wherein the second layer (12) is formed on the top surface (11A) and the sloped surface (11B) of the first layer (11, 11'),

**characterised in that**

$$T_{2\text{-}t} > T_{2\text{-}s}$$

is satisfied, where

$T_{2\text{-}t}$ denotes a thickness of a part of the second layer (12) formed on the top surface (11A) of the first layer (11, 11'), and
$T_{2\text{-}s}$ denotes a thickness of a part of the second layer (12) formed on the sloped surface (11B) of the first layer (11, 11').

2. A compound semiconductor layer stack (10) comprising:

a first layer (11, 11') being formed on a base (14, 14') and including an island-shaped $Al_{x1}In_{y1}Ga_{(1-x1-y1)}N$;
a second layer (12) being formed on the first layer (11, 11') and including $Al_{x2}In_{y2}Ga_{(1-x2-y2)}N$; and
a third layer (13) being formed on an entire surface of the second layer (12) including a top of the second layer (12), the third layer (13) including $Al_{x3}Ga_{(1-x3)}N$,
the third layer (13) having a top surface (13A) that is flat,
provided that the following hold true:

$$0 \leq x1 < 1;\ 0 \leq x2 < 1;\ 0 \leq x3 < 1;\ 0 \leq y1 < 1;\ \text{and}\ 0 < y2 < 1,$$

wherein the first layer has a forward tapered sloped surface (11B) and a flat top surface (11A),
wherein the second layer (12) is formed on the top surface (11A) and the sloped surface (11B) of the first layer (11, 11'),
**characterised in that**

$$T_{2\text{-}t} > T_{2\text{-}s}$$

is satisfied, where

$T_{2\text{-}t}$ denotes a thickness of a part of the second layer (12) formed on the top surface (11A) of the first layer (11, 11'), and
$T_{2\text{-}s}$ denotes a thickness of a part of the second layer (12) formed on the sloped surface (11B) of the first layer (11, 11').

3. The compound semiconductor layer stack (10) according to claim 2, wherein

a mask layer (16) is formed on the base (14, 14'), and
the first layer (11, 11') is formed on a part of the base (14, 14') not covered with the mask layer (16).

4. The compound semiconductor layer stack (10) according to claim 3, wherein the mask layer (16) includes one type of a material selected from the group consisting of SiN, $SiO_2$, and $TiO_2$.

5. The compound semiconductor layer stack (10) according to claim 1, wherein:

the first layer (11, 11') is doped with impurities including Si or Mg, and
a doping concentration is $1 \times 10^{19}$ $cm^{-3}$ or more; or
a multilayer structure (18) of an AlInGaN layer (18A) and an AlGaN layer (18B) is formed on the third layer (13).

6. The compound semiconductor layer stack (10) according to claim 1, wherein:

the base (14, 14') includes an InGaN layer; or
the base (14, 14') includes an InGaN layer, and
an atomic percentage of In atoms in the InGaN layer is 0.5% or more and 30% or less.

7. A light-emitting device comprising:

the compound semiconductor layer stack (10) according to anyone of the claims 2 to 6;
a first compound semiconductor layer (21) formed on the compound semiconductor layer stack (10);
an active layer (23) formed on the first compound semiconductor layer (21);
a second compound semiconductor layer (22) formed on the active layer (23);
a second electrode (26) electrically coupled to the second compound semiconductor layer (22); and
a first electrode (25) electrically coupled to the first compound semiconductor layer (21).

**Patentansprüche**

1. Verfahren zum Bilden eines Verbindungshalbleiterschichtstapels, das Verfahren umfassend:

Bilden, auf einer Basis (14, 14'), einer ersten Schicht (11, 11'), die ein inselförmiges $Al_{x1}In_{y1}Ga_{(1-x1-y1)}N$ einschließt;
Bilden, auf der ersten Schicht (11, 11'), einer zweiten Schicht (12), die $Al_{x2}In_{y2}Ga_{(1-x2-y2)}N$ einschließt; und
Bilden, auf einer gesamten Oberfläche der zweiten Schicht (12), die eine Oberseite der zweiten Schicht (12) einschließt, einer dritten Schicht (13), die $Al_{x3}Ga_{(1-x3)}N$ einschließt, wobei die dritte Schicht eine obere Oberfläche (13A) aufweist, die flach ist,
vorausgesetzt, dass Folgendes zutrifft:

$$0 \leq x1 < 1;\ 0 \leq x2 < 1;\ 0 \leq x3 < 1;\ 0 \leq y1 < 1;\ \text{und}\ 0 < y2 < 1,$$

wobei die erste Schicht (11, 11') eine nach vorne verjüngte geneigte Oberfläche (11B) aufweist und eine flache obere Oberfläche (11A) gebildet ist,
wobei die zweite Schicht (12) auf der oberen Oberfläche (11A) und der geneigten Oberfläche (11B) der ersten Schicht (11, 11') gebildet ist,
**dadurch gekennzeichnet, dass**

$$T_{2\text{-}t} > T_{2\text{-}s}$$

erfüllt ist, wobei
$T_{2\text{-}t}$ eine Dicke eines Teils der zweiten Schicht (12) bezeichnet, die auf der oberen Oberfläche (11A) der ersten Schicht (11, 11') gebildet ist, und
$T_{2\text{-}s}$ eine Dicke eines Teils der zweiten Schicht (12) bezeichnet, die auf der geneigten Oberfläche (11B) der ersten Schicht (11, 11') gebildet ist.

2. Verbindungshalbleiterschichtstapel (10), umfassend:

eine erste Schicht (11, 11'), die auf einer Basis (14, 14') gebildet ist und ein inselförmiges $Al_{x1}In_{y1}Ga_{(1-x1-y1)}N$ einschließt;
eine zweite Schicht (12), die auf der ersten Schicht (11, 11') gebildet ist und $Al_{x2}In_{y2}Ga_{(1-x2-y2)}N$ einschließt; und
eine dritte Schicht (13), die auf einer gesamten Oberfläche der zweiten Schicht (12), die eine Oberseite der zweiten Schicht (12) einschließt, gebildet ist, wobei die dritte Schicht (13) $Al_{x3}Ga_{(1-x3)}N$ einschließt,
wobei die dritte Schicht (13) eine obere Oberfläche (13A) aufweist, die flach ist, vorausgesetzt, dass Folgendes zutrifft:

$$0 \leq x1 < 1;\ 0 \leq x2 < 1;\ 0 \leq x3 < 1;\ 0 < y1 < 1;\ \text{und}\ 0 < y2 < 1,$$

wobei die erste Schicht eine nach vorne verjüngte geneigte Oberfläche (11B) und eine flache obere Oberfläche (11A) aufweist,
wobei die zweite Schicht (12) auf der oberen Oberfläche (11A) und der geneigten Oberfläche (11B) der ersten Schicht (11, 11') gebildet ist,
**dadurch gekennzeichnet, dass**

$$T_{2\text{-}t} > T_{2\text{-}s}$$

erfüllt ist, wobei

$T_{2-t}$ eine Dicke eines Teils der zweiten Schicht (12) bezeichnet, die auf der oberen Oberfläche (11A) der ersten Schicht (11, 11') gebildet ist, und

$T_{2-s}$ eine Dicke eines Teils der zweiten Schicht (12) bezeichnet, die auf der geneigten Oberfläche (11B) der ersten Schicht (11, 11') gebildet ist.

3. Verbindungshalbleiterschichtstapel (10) nach Anspruch 2, wobei

eine Maskenschicht (16) auf der Basis (14, 14') gebildet wird, und

die erste Schicht (11, 11') auf einem Teil der Basis (14, 14') gebildet wird, der nicht mit der Maskenschicht (16) bedeckt ist.

4. Verbindungshalbleiterschichtstapel (10) nach Anspruch 3, wobei die Maskenschicht (16) eine Art von Material einschließt, das aus der Gruppe ausgewählt ist, bestehend aus SiN, $SiO_2$, und $TiO_2$.

5. Verbindungshalbleiterschichtstapel (10) nach Anspruch 1, wobei:

die erste Schicht (11, 11') mit Verunreinigungen, die Si oder Mg einschließen, dotiert ist, und

eine Dotierungskonzentration $1 \times 10^{19}$ cm$^{-3}$ oder mehr beträgt; oder

eine Mehrschichtstruktur (18) aus einer AllnGaN-Schicht (18A) und einer AlGaN -Schicht auf der dritten Schicht (13) (18B) gebildet ist.

6. Verbindungshalbleiterschichtstapel (10) nach Anspruch 1, wobei:

die Basis (14, 14') eine InGaN-Schicht einschließt; oder

die Basis (14, 14') eine InGaN-Schicht einschließt, und

ein Atomprozentsatz an In-Atomen in der InGaN-Schicht 0,5 % oder mehr und 30 % oder weniger beträgt.

7. Lichtemittierende Vorrichtung, umfassend:

den Verbindungshalbleiterschichtstapel (10) nach einem der Ansprüche 2 bis 6,

eine erste Verbindungshalbleiterschicht (21), die auf dem Verbindungshalbleiterschichtstapel (10) gebildet ist;

eine aktive Schicht (23), die auf der ersten Verbindungshalbleiterschicht (21) gebildet ist;

eine zweite Verbindungshalbleiterschicht (22), die auf der aktiven Schicht (23) gebildet ist;

eine zweite Elektrode (26), die mit der zweiten Verbindungshalbleiterschicht (22) elektrisch gekoppelt ist; und

eine erste Elektrode (25), die mit der ersten Verbindungshalbleiterschicht (21) elektrisch gekoppelt ist.

## Revendications

1. Procédé permettant de former un empilement de couches semi-conductrices composées, le procédé comprenant :

la formation, sur une base (14, 14'), d'une première couche (11, 11') comportant un $Al_{x1}In_{y1}Ga_{(1-x1-y1)}N$ en forme d'îlot ;

la formation, sur la première couche (11, 11'), d'une deuxième couche (12) comportant un $Al_{x2}In_{y2}Ga_{(1-x2-y2)}N$ ; et

la formation, sur une surface entière de la deuxième couche (12) comportant un sommet de la deuxième couche (12), d'une troisième couche (13) comportant un $Al_{x3}Ga_{(1-x3)}N$, la troisième couche ayant une surface supérieure (13A) qui est plate,

à condition que les conditions suivantes soient satisfaites :

$$0 \leq x1 < 1 \; ; \; 0 \leq x2 < 1 \; ; \; 0 \leq x3 < 1 \; ; \; 0 \leq y1 < 1 \; ; \; \text{et } 0 < y2 < 1,$$

dans lequel la première couche (11, 11') ayant une surface inclinée conique vers l'avant (11B) et une surface supérieure plate (11A) est formée,

dans lequel la deuxième couche (12) est formée sur la surface supérieure (11A) et la surface inclinée (11B) de la première couche (11, 11'),

**caractérisé en ce que**

$$T_{2\text{-}t} > T_{2\text{-}s}$$

est satisfaite, où

$T_{2\text{-}t}$ désigne une épaisseur d'une partie de la deuxième couche (12) formée sur la surface supérieure (11A) de la première couche (11, 11'), et

$T_{2\text{-}s}$ désigne une épaisseur d'une partie de la deuxième couche (12) formée sur la surface inclinée (11B) de la première couche (11, 11').

2. Empilement de couches semi-conductrices composées (10) comprenant :

une première couche (11, 11') formée sur une base (14, 14') et comportant un $Al_{x1}In_{y1}Ga_{(1\text{-}x1\text{-}y1)}N$ en forme d'îlot ;
une deuxième couche (12) étant formée sur la première couche (11, 11') et comportant un $Al_{x2}In_{y2}Ga_{(1\text{-}x2\text{-}y2)}N$ ; et
une troisième couche (13) formée sur une surface entière de la deuxième couche (12) comportant un sommet de la deuxième couche (12), la troisième couche (13) comportant un $Al_{x3}Ga_{(1\text{-}x3)}N$,
la troisième couche (13) a une surface supérieure (13A) qui est plate, à condition que les conditions suivantes soient satisfaites :

$$0 \leq x1 < 1 \ ; \ 0 \leq x2 < 1 \ ; \ 0 \leq x3 < 1 \ ; \ 0 \leq y1 < 1 \ ; \ \text{et} \ 0 < y2 < 1,$$

dans lequel la première couche a une surface inclinée conique vers l'avant (11B) et une surface supérieure plate (11A),
dans lequel la deuxième couche (12) est formée sur la surface supérieure (11A) et la surface inclinée (11B) de la première couche (11, 11'),
**caractérisé en ce que**

$$T_{2\text{-}t} > T_{2\text{-}s}$$

est satisfaite, où

$T_{2\text{-}t}$ désigne une épaisseur d'une partie de la deuxième couche (12) formée sur la surface supérieure (11A) de la première couche (11, 11'), et

$T_{2\text{-}s}$ désigne une épaisseur d'une partie de la deuxième couche (12) formée sur la surface inclinée (11B) de la première couche (11, 11').

3. Empilement de couches semi-conductrices composées (10) selon la revendication 2, dans lequel

une couche de masque (16) est formée sur la base (14, 14'), et
la première couche (11, 11') est formée sur une partie de la base (14, 14') non rec ouverte par la couche masque (16).

4. Empilement de couches semi-conductrices composées (10) selon la revendication 3, dans lequel la couche de masque (16) comporte un type d'un matériau choisi dans le groupe constitué de SiN, $SiO_2$, and $TiO_2$.

5. Empilement de couches semi-conductrices composées (10) selon la revendication 1, dans lequel :

la première couche (11, 11') est dopée avec des impuretés comportant du Si ou du Mg, et
une concentration de dopage de $1 \times 10^{19}$ cm$^{-3}$ ou plus ; ou
une structure multicouche (18) composée d'une couche AlInGaN (18A) et d'une couche AlGaN (18B) est formée sur la troisième couche (13).

6. Empilement de couches semi-conductrices composées (10) selon la revendication 1, dans lequel :

la base (14, 14') comporte une couche InGaN ; ou
la base (14, 14') comporte une couche InGaN, et
un pourcentage atomique d'atomes In dans la couche InGaN est supérieur ou égal à 0,5 % et inférieur ou égal à 30 %.

7. Dispositif électroluminescent comprenant :

un empilement de couches semi-conductrices composées (10) selon l'une quelconque des revendications 2 à 6,
une première couche semi-conductrice composée (21) formée sur l'empilement de couches semi-conductrices composées (10) ;
une couche active (23) formée sur la première couche semi-conductrice composée (21) ;
une seconde couche semi-conductrice composée (22) formée sur la couche active (23) ;
une seconde électrode (26) couplée électriquement à la seconde couche semi-conductrice composée (22) ; et
une première électrode (25) couplée électriquement à la première couche semi-conductrice composée (21).

[ FIG. 1 ]

FIG. 1

[ FIG. 2 ]

FIG. 2A

FIG. 2B

FIG. 2C

FIG. 2D

[ FIG. 3 ]

FIG. 3

[ FIG. 4 ]

FIG. 4

[ FIG. 5 ]

FIG. 5

[ FIG. 6 ]

FIG. 6

[ FIG. 7 ]

FIG. 7

[ FIG. 8 ]

FIG. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007214380 A
- JP 3847000 B
- US 2004262624 A1
- JP 2003158295 A